(19) Europäisches Patentamt
European Patent Office
Office européen des brevets

(11) EP 4 610 390 A1

(12) **EUROPEAN PATENT APPLICATION**

(43) Date of publication:
03.09.2025 Bulletin 2025/36

(21) Application number: 24160774.6

(22) Date of filing: 01.03.2024

(51) International Patent Classification (IPC):
$C23C\ 14/34$ (2006.01)

(52) Cooperative Patent Classification (CPC):
C23C 14/3414; C22C 1/02; C22C 5/06;
C23C 14/185; H01J 37/3426

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Materion Advanced Materials Germany
GmbH
63755 Alzenau (DE)

(72) Inventors:
• KONIETZKA, Uwe
63826 Geiselbach (DE)
• WAGNER, Jens
60435 Frankfurt (DE)
• SCHLOTT, Martin
63075 Offenbach (DE)

(74) Representative: Kador & Partner Part mbB
Corneliusstraße 15
80469 München (DE)

(54) **AG-BASED ALLOY SPUTTERING TARGET FOR SPUTTERING OF LAYERS WITH IMPROVED REFLECTIVITY**

(57) The present invention relates to a sputtering target based on silver (Ag) and comprising one alloying metal, selected from the group consisting of indium (In), tin (Sn), antimony (Sb) and bismuth (Bi), and a low amount of aluminum (Al), to a process for the production thereof and to layers obtained by sputtering of such a target.

Fig. 1:

Reflectivity of 200 nm layers

(legend: —— Ag, — — AgInAl, ----- AgIn)

EP 4 610 390 A1

## Description

The present invention relates to a sputtering target comprising an alloy based on silver (Ag) which further contains an alloying metal selected from the group consisting of indium (In), tin (Sn), antimony (Sb) and bismuth (Bi) or any combination thereof, and a low amount of aluminum (Al), to a process for the production of said sputtering target and to layers obtained by sputtering of said target.

Sputtering targets made of silver-based alloys are known and are often used to produce thin films/layers for glazing applications such as for coating glass, or as reflective-layers in optical storage media and displays.

For example, European Patent Application EP 2 647 737 A1 describes sputtering targets of alloys based on silver and at least one further component from indium (In), tin (Sn), antimony (Sb) or bismuth (Bi). These alloys are characterized by high corrosion resistance and are, inter alia, used for the preparation of displays. However, if compared to unalloyed silver layers, additions of these alloying components tend to impair reflectivity of the prepared layers.

Thus, there is still a need for further alloys based on silver, which - when used for the formation of reflective layers - yield improved reflectivity of such layers, and respective sputtering targets comprising such alloys. In particular, there is a need for such sputtering targets comprising silver alloys for producing reflective layers in displays. It is also important that the prepared layers have relative low film resistivity.

Furthermore, it is generally desirable and important that when producing reflective layers, a uniform thickness of such layers is obtained. Still further, it is also generally desirable and important to avoid arcing during the sputtering process. Thus, the Ag alloys used for sputtering of said layers should also achieve these further objectives.

### *Sputtering target*

The above-discussed aims are achieved by the provision of the sputtering target as defined by the appended claims.

Accordingly, the present invention relates to a sputtering target comprising, or consisting of, an AgXAl alloy consisting of Ag, from 0.20 to 0.80 wt.-% of an alloying metal X, which is selected from the group consisting of indium (In), tin (Sn), antimony (Sb) and bismuth (Bi) and any combination thereof, and from 100 to 300 ppm-wt. of Al (aluminum).

It has been surprisingly found that the sputtering targets according to the present invention comprising AgXAl alloys with a content of from 100 to 300 ppm-wt. of Al are very useful, e.g., in the application in reflective or semi-reflective layers. These layers are also characterized by a relatively low film resistivity that is in the same range as the film resistivity of the respective AgX alloy layers.

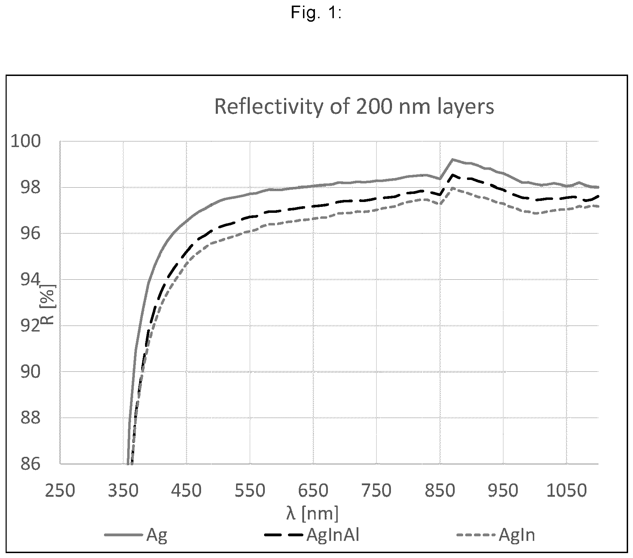

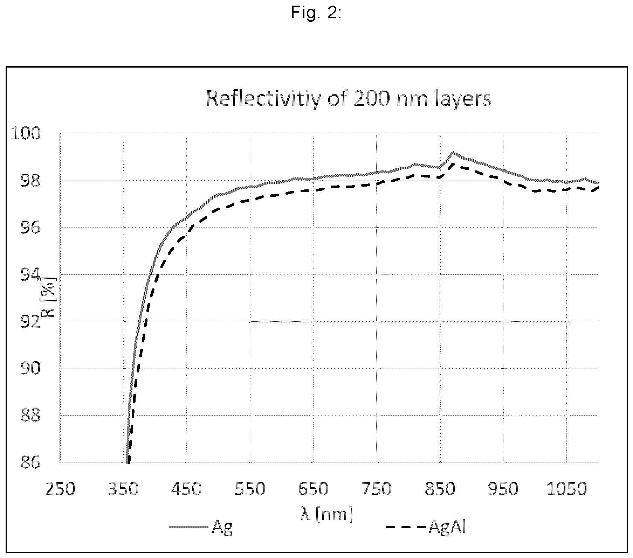

The obtained layers are characterized by very good reflectivity, which is enhanced when compared to AgX alloy layers with the same content of X but which do not contain Al. This improvement is depicted in Fig. 1. This is unexpected and surprising as reflectivity of pure Ag layers could not be enhanced with a similar amount of Al. In contrast, addition of even such small amounts of Al resulted in a decrease of reflectivity (as measured on 200 nm layers and depicted in Fig. 2). It is generally known that addition of alloying elements to the Ag metal impairs reflectivity of Ag layers. Although, it was surprising that this negative effect could already be measured for addition of such small amounts of Al as 190 ppm-wt.

Application of Al in Ag-based alloys comprising In, Sn, Sb and/or Bi was generally not recommended by the prior art. For example, European Patent Application EP 2 647 737 A1 suggests keeping "impurity elements" such as Al at very low contents of less than 0.5 ppm-wt. in these Ag-based alloys in order to minimize introduction of oxides into the alloys.

Sputtering targets of materials with higher oxide contents have the drawback to produce splashes (e.g., arcing or micro-arcing) when the layers are deposited on substrates. This leads to layer defects. For example, in displays, these defects may impair the function of one or more pixels.

However, the present invention provides Ag-based alloys comprising In, Sn, Sb or Bi or any combination thereof, wherein the alloys additionally comprise Al (i.e., being an AgXAl alloy) and do not suffer from the drawbacks described in the prior art. This is advantageously reached by employing the process according to the present invention, in which an AgXAl alloy is formed by the addition of Al to the Ag metal or AgX alloy.

Further, employment of Al that *per* se has strong oxygen affinity further improves the adhesion to glass and other substrates, and hence increases agglomeration resistance of AgXAl alloys over AgX alloys.

The AgXAl alloy consists of Ag, an alloying metal X, which is selected from the group consisting of In, Sn, Sb and Bi, and any combination thereof, and of Al. Preferably, the alloying metal X is selected from In, Sn, Sb and Bi, and any combination thereof, more preferably In, Sn and a combination thereof and most preferably it comprises, or consists of, In. In particular, AgInAl alloys or the layers produced thereof are characterized by excellent corrosion resistance and reflectivity at good film resistivity.

The selected alloying metal X confers corrosion resistance on the Ag metal, e.g., when applied to substrates as a reflective layer in technical applications. Reflectivity of layers of AgXAl alloys is enhance due to the presence of Al compared to respective AgX alloys without Al.

The content of the alloying metal(s) X in the AgXAl alloy is in total from 0.20 to 0.80 wt.-%, preferably from 0.30 to 0.70 wt.-% and more preferably from 0.40 to 0.60 wt.-%. In one preferred embodiment, the content of the alloying metal X in the AgXAl alloy is 0.50 wt.-%, and the alloying metal X is preferably In.

The content of Al in the AgXAl alloy is from 100 to 300 ppm-wt., preferably from 120 to 250 ppm-wt. and more preferably from 150 to 220 ppm-wt. It was surprisingly found that such low contents of Al are sufficient to improve reflectivity of AgX alloys when applied as layers. This was particularly surprising as an Al content of about 190 ppm-wt.-% did not enhance reflectivity of unalloyed 200 nm Ag layers (Fig. 2).

These low contents of Al have the advantage that only small contents of oxides may be contained in the alloy originating from Al.

However, it is further preferable that the main part of Al is incorporated in the AgXAl alloy in metallic state, i.e., is not present as oxide. This further facilitates solution and homogeneous distribution of Al in the AgXAl alloy and, and uniform adhesion of the prepared layer. Moreover, it has been found that it is advantageous if Al is in its metallic state in order to improve physical properties of the AgXAl alloy. Especially micro-arcing events are reduced if Al is mainly incorporated in its metallic form.

Thus, it is preferable that not more than two, more preferably not more than one and even more preferably no inclusion clusters of Al in the form of an oxide (e.g., $Al_2O_3$) with a cluster size of more than 1 $\mu m^2$ are detectable in an area of 1 $mm^2$, for a total of five areas at arbitrary positions of a scanning electron microscopy (SEM) sample, and measured as described herein below. A low number of clusters is indicative of a high content of the alloying element being in metallic state. Usually, in an area of 1 $mm^2$ a maximum of one inclusion cluster was detected.

It is also preferable that the AgXAl alloy has an oxygen content of less than 50 ppm-wt., preferably less than 20 ppm-wt., more preferably less than 10 ppm-wt., even more preferably less than 10 ppm-wt and most preferably less than 5 ppm-wt. The oxygen content is measured as described herein below and it is indicative of the oxide content of the AgX alloy.

Low contents of oxides are preferable to avoid arcing and micro-arcing of the AgXAl alloy sputtering target. Such electric discharges would otherwise generate splashes that could harm the functionality of the deposited layer. They were not observed in the preparation of layers using the sputtering targets according to the present invention.

In order to achieve a uniform layer thickness and homogeneity, it is also preferred that the AgXAl alloy has an average grain size of less than 150 $\mu m$, such as in the range of from 10 to 150, preferably from 20 to 120 $\mu m$. In particular, such small grain sizes are favorable for sputtering targets of planar or tubular form having a length of 1 m or more.

It is further preferred that the maximum grain size is less than 300 $\mu m$, for example that the grain sizes range from 5 to less than 300 $\mu m$. Measurement of grain sizes is generally performed according to DIN EN ISO 643 as described herein below.

It is also important that the AgXAl alloy has a high metallic purity. A minimum metallic purity of 99.9 wt.-% is required for the AgXAl alloy. Preferably, the AgXAl alloy has a metallic purity of at least 99.95 wt.-% (3N5) and more preferably of at least 99.99 wt.-% (4N), based on the Ag matrix. Metallic purity denotes the purity of the metal or alloy, wherein only elements in the metal or alloy count as impurities, which were not intentionally added. In case of an AgXAl alloy, neither X nor Al would be considered an impurity.

The layers prepared with the sputtering targets are characterized by uniform thickness and homogeneous distribution of the alloying metal X and Al in the AgXAl alloy. Further, they are also characterized by excellent physical properties, e.g., electrical and optical properties in terms of film resistivity and reflectivity.

Preferably, the film resistivity and reflectivity of the AgXAl alloy layers are similar to or improved over the film resistivity and reflectivity of AgX alloys of the same X content but without Al being present (e.g., as determined on a 200 nm or 350 nm layer).

Preferably, the film resistivity of AgXAl alloy layers is in a similar range compared to the film resistivity of a AgX alloy layer of same X content but without Al. Film resistivity is determined on a sputtered layer of about 350 nm in thickness (on a glass substrate), and is given as $\rho$ in $\mu\Omega cm$. Generally, the range for film resistivity of the AgXAl alloy layer of a thickness of 100 to 500 nm is in the range of from 2.5 to 3.5 $\mu\Omega cm$.

Preferably, the reflectivity of AgXAl alloy layers is higher, preferably by at least 0.3 %, more preferably by at least 0.5 %, on an absolute scale, compared to the reflectivity of an AgX alloy layer of same X content but without Al. Reflectivity is determined by spectroscopy on a sputtered layer of about 200 nm in thickness (on a glass substrate) at a wavelength of 550 nm as described herein below, and is given in %.

### Process

The present invention also relates to a process for producing the sputtering target, i.e., a sputtering target comprising an AgXAl alloy consisting of Ag, from 0.20 to 0.80 wt.-% of an alloying metal X, which is selected from the group consisting of In, Sn, Sb and Bi and any combination thereof, and from 100 to 300 ppm-wt. of Al, in any of the embodiments and with any of the features described above.

For the production of the sputtering target, it is important that the AgXAl alloy is provided with homogeneously distributed Al in mainly metallic form, and that the oxide content of the AgXAl alloy is kept at low level.

It is generally preferred that the Ag metal and the alloying metal X are of high metallic purity, such as a metallic purity of at least 99.9 wt.-% (3N), preferably at least 99.95 wt.-% (3N5) and more preferably at least 99.99 wt.-% (4N) or even higher.

It is also preferred that the Al used is of high metallic purity, such as a metallic purity of at least 99.5 wt.-% (2N5), preferably at least 99.9 wt.-% (3N) and more preferably at least 99.95 wt.-% (3N5) or even higher.

The process according to the present invention comprises preparing the AgXAl alloy by heating Ag metal pieces in an inert container to a temperature range of from 980 to 1200 °C under vacuum or at inert gas conditions in the presence of Al and the alloying metal X. In this way, a melt of the AgXAl alloy is directly prepared. Additional steps such as a dilution of a pre-alloy to the final AgXAl alloy are not required.

It was surprisingly found that the process according to the present invention, wherein Ag metal is used as the starting material and wherein Al is directly dispensed into the Ag metal leads to a very homogeneous alloy with very low oxide content. Thus, good distribution of Al and the alloying metal X in the Ag matrix is reached, and oxidation of the Al could be minimized.

It is generally known in the art to prepare alloys with low contents of alloying elements in a 2-step process. Thus, first Ag alloys with higher contents of alloying elements (e.g., such as Ag alloys with the 10-fold content of the alloying elements) are prepared. These alloys are further "diluted" - in a second step - by adding Ag (or Ag alloy) granules to reach the Ag alloy with the required small content of the alloying elements. However, this 2-step process will increase the oxidation risk for the alloying elements. As a consequence, the final composition may be significantly off from the intended one. In particular, a highly oxidative metal as Al may be present to a significant amount as oxide. This is particularly disadvantageous as the risk of arcing highly increases.

By using the process according to the present invention, these drawbacks can be avoided.

Generally, by the process according to the present invention, a melt is provided, wherein Al and the alloying metal X are dispensed into an Ag melt. For this process, preferably, careful degassing of vacuum chamber and crucible is carried out. This is advantageous in particular for the addition of Al that has high oxygen affinity. The melting process is carried out under vacuum and/or in an inert gas atmosphere (e.g., argon).

The Ag melt is prepared by heating of the Ag metal pieces, preferably as Ag granules, in an inert and optionally slightly reducing container (e.g., an alumina or graphite crucible) to a temperature in the range of from 980 to 1200 °C, more preferably from 1000 to 1100 °C. An inert container denotes here a container that resists high temperature of 1200 °C and above without crashing or release of components into the melt under vacuum or inert gas conditions. Inert and optionally slightly reducing containers may e.g., be crucibles made of high purity alumina, graphite, quartz, or the like, or cold hearth crucibles.

In a preferred embodiment, degassed vacuum chamber and crucible for Vacuum Induction Melting, ideally by use of a diffusion pump, are employed.

The melt can then be poured into a mold (e.g., a graphite or steel mold). If the melt is allowed to cool and solidify in this form, a solid shaped body is obtained.

Generally, granules, chips, flakes, platelets and/or wire cut-offs are suitable as Ag metal pieces, pieces of the alloying metal X and Al pieces.

In preferred embodiments of the process, Al and the alloying metal X, both in the form of pieces, and the Ag metal pieces are prepared in stacks. First a stack 1 of Ag metal pieces is provided. A stack 2 of Al and the alloying metal X is placed on stack 1. Stack 2 is then covered with a stack 3 of Ag metal pieces (stack 1 and stack 3 make up 100 % of the Ag metal pieces), and the Ag metal pieces and pieces of Al and the alloying metal X are heated to prepare an Ag melt with Al and the alloying metal X being dispensed into the Ag melt.

In these embodiments, preferably, an inert or slightly reducing crucible (e.g., an alumina or graphite crucible) is filled with Ag granules to form stack 1. Pieces of Al and the alloying metal X, such as small pieces like chips, platelets, or wire cut-offs are then positioned in the crucible on top of the Ag granules (preferably near the center) to form stack 2, and then are covered with the remaining Ag granules as stack 3. The Ag melt is formed slowly under heating the crucible to a temperature in the range of from 980 to 1200 °C.

Preferably, stack 1 comprises a higher amount of the Ag metal pieces (e.g., granules) than stack 3, such as 60 to 90 %, preferably 65 to 85 % of the Ag metal pieces used.

In some embodiments of the process, Al and the alloying metal X can also be added into the liquid Ag melt via a late charge unit.

For all embodiments of the process, the melt is preferably maintained at the melting temperature for a sufficiently long time to enable a homogeneous distribution of Al and the alloying metal X in the Ag matrix. This dwelling time depends on the total weight of the melt and the agitation during this dwelling time. Typical dwelling times are 10 to 30 minutes. Induction melting is preferred here since it enables intense stirring. Afterwards the melt is cast e.g., into a steel or graphite mold. In this way, a solid block or cylinder of the AgXAl alloy is produced.

The production process preferably further comprises at least one, more preferably at least two of the steps:

a) hot working such as rolling, forging and/or extrusion at a temperature in the range of from 400 to 800 °C,
b) cold working, such as cold rolling, forging or extrusion,
c) annealing at a temperature in the range of from 300 to 450 °C for a time range of between 30 min and 3 h, depending also on the mass of the plate or tube.

Suitable additional steps of the production process which can be used are described e.g., in EP 3 168 325 A1.

The present invention also relates to a sputtering target in any of the embodiments and with any of the features described above, produced by the process according to the present invention.

### Applications

The sputtering target according to the present invention may be used for deposition of Ag alloy layers where high corrosion resistance together with high reflectivity, low film resistivity and low agglomeration tendency is required or wishful for Ag layers. For example, the Ag alloys may be deposited as layers of displays. Preferably such layers are used as reflective layers.

Accordingly, the present invention also relates to a layer formed by sputtering the AgXAl alloy from the sputtering target according to any one of the embodiments described above, on a substrate.

The layers may be formed by Physical Vapor Deposition (PVD), such as sputtering, ion beam deposition, pulsed laser deposition and combinations thereof, from the AgXAl alloy. Preferably, the layers are deposited by magnetron sputtering.

### Uses

Accordingly, the sputtering targets according to the present invention may be used in the applications described above.

Thus, the present invention also relates to the use of Al in an AgX alloy to enhance reflectivity of an AgX alloy, wherein X is an alloying metal, selected from the group consisting of In, Sn, Sb and Bi, and any combination thereof. It is to be understood that reflectivity is enhanced in a layer formed by the alloy. It is also to be understood that an AgXAl alloy is formed by the addition of Al to the AgX alloy.

Preferably, the AgX alloy consists of Ag and from 0.20 to 0.80 wt.-% of the alloying metal X.

In a preferred embodiment, Al is used in an amount of from 100 to 300 ppm-wt. relative to the weight of the final AgXAl alloy.

The present invention will further be illustrated on the basis of the following examples with reference to the figures, wherein:

Fig. 1: shows reflectivity of sputtered Agin 0.5 wt.-% Al190ppm-wt.%, Agin 0.5 wt.-% and Ag layers of 200 nm thickness on glass; and

Fig. 2: shows reflectivity of sputtered AgAl 190 ppm-wt.% and Ag layers of 200 nm thickness on glass.

### Measurement methods

The following methods were used to measure the parameters described herein.

#### a) Grain size

For the optical determinations by way of SEM and light microscope, the sputtering target samples were obtained by water-jet cutting respective pieces from a target plate or hollow cylinder followed by a first milling step.

The samples were embedded in a resin with the sputter surface up and ground using increasingly finer grain sizes of 120 to 4000 grid and, in the final step, polished with diamond paste. Thereafter, the surface of the samples was etched with hydrogen peroxide/ammonia at 25 °C for 60 s.

The grain sizes were evaluated as follows: From each micrograph a photo is taken. The magnifications were set in a way that a line drawn over a photograph of the etched samples crosses between 8 and 30 grain boundaries.

Each micrograph was evaluated by the line intersection method (ASTM E112) and the mean grain size was calculated for each of the 10 samples. In addition, the largest grain found by the method is noted for each of the 10 samples.

The average grain size M was determined by the linear intercept method according to DIN EN ISO 643 according to the following equation:

$$M=(L*p)/(N*m)$$

wherein

    L: length of the measurement line
    p: number of measurement line
    N: number of the cut objects
    m: magnification

The values were determined at 3*3=9 different measurement locations, each in three depths: 0 mm, 3 mm and 6 mm. Thereafter, the arithmetic mean from the 9 measurement results is found.

#### b) Determination of oxygen content

Chips (about 1 gram) were taken from the sputtering target by a press-drill, etched with nitric acid, carefully dried and measured for oxygen content by the carrier gas method by using a Horiba EMGA-920 system according to standard protocol.

c) Determination of the metallic state of alloying element via SEM

The polished samples from the grain size measurement were taken to an SEM (scanning electron microscope) to investigate them for oxide inclusions. Under high resolution the samples were scanned for oxide clusters. With element maps it was checked whether such clusters were present, which normally was not the case, and whether they were showing also the fingerprint of Al.

In detail, five arbitrary areas of 1 mm$^2$ on the SEM sample were analyzed for the presence of inclusion clusters of Al in the form of an oxide with a cluster size of more than 1 $\mu$m$^2$. A low number of clusters is indicative of a high content of Al being in metallic state. A number of not more than two inclusion clusters per area in five areas was considered to represent a high metallic state of Al.

d) Layer thickness of the layer deposited by sputtering

The layer thicknesses were measured by way of a stylus-type profilometer, such as KLA Tencor D-500. The sample preparation was carried out by partially covering the substrate with Kapton tape, and the correspondingly covered region is not sputtered. After the covering is removed, the layer thickness at the created step between the coated and non-coated regions can be ascertained. The diamond needle of the measuring device measures the layer thickness by way of deflection. The device was calibrated to 1 $\mu$m using the supplied standard. The measurement was repeated in 10 different locations of the sample, and the mean value was found.

e) Optical reflection (reflectivity) of the layer deposited by way of sputtering

The measurement of the direct reflection (angle of incidence and angle of reflection are the same) took place on the coated glass substrates using Perkin Elmer Lambda 35 in the wavelength range of 250 to 1100 nm.

f) Film resistivity

The resistance of the thin film samples was measured using a four point probe from Nagy company, type SD 510, at room temperature on 10 respective samples. The arithmetic mean was determined. The resistivity of the layer is calculated by multiplying the sheet resistance by the layer thickness and has the unit $\mu\Omega$cm.

**Examples**

Example 1:

*Preparation of sputtering targets*

An AgInAl sputtering target with an In content of 0.5 wt.-% and an Al content of 190 ppm-wt. was produced by vacuum induction melting and casting, followed by hot rolling and annealing to obtain a sputtering target of large dimensions. For analytical methods, a sputtering target having the dimensions of 488 mm × 88 mm 6 mm was prepared from the full-size target.

In detail, of Ag granules of 4N purity were charged in a vacuum baked graphite crucible together with small Al pieces and In pieces, both of 4N purity. The main portion of the Ag granules was herby placed first in the crucible, then the Al and In pieces were added around the center on the Ag granules stack. The remaining Ag granules were then placed as a top stack. The arrangement was slowly heated to a pouring temperature of 1040 °C. Melting took place in a conventional vacuum induction furnace in degassed vacuum chamber (base pressure $1 \times 10^{-3}$ to $2 \times 10^{-3}$ mbar).

The melt was held for about ½ h for degassing and homogenization and then cast into a cold steel mold to obtain a solid block for subsequent sputtering target production.

Hot rolling was done in multiple passes after preheating the cast ingot to a temperature in the range of 650 to 750 °C for about 2 h, which produces a particularly fine grain structure. Annealing of the rolled plate was done for about 1 h at a temperature in the range of 300 to 350 °C.

The target had a good homogeneity with low deviation from the average Al content, as determined on six samples taken at six arbitrary positions along the target length. The oxygen content was as low as 3 ppm. Only one oxide inclusion cluster per 1 mm$^2$ area (in the total of five areas) was detectable. No arcing effects occurred. The average grain size was about 81 $\mu$m.

Example 2:

*Preparation of layers*

The sputtering target prepared as described above was used to prepare layers on glass. Coatings comprising one layer of the AgInAl alloy were deposited by means of magnetron sputtering on 50 × 50 × 1 mm$^3$ on Eagle XG® glass substrates from Corning in an in-line coater. The layer thickness was 200 nm or 350 nm. For reference, layers of unalloyed Ag metal, Agin 0.5 wt.-% and AgAl 190 ppm-wt.% were also deposited at otherwise the same process conditions.

Further parameters of the process were:

Final pressure before process: $1 \times 10^{-6}$ mbar
Process pressure: $3 \times 10^{-3}$ mbar
Ar-flow: 180 sccm
Power density: 1.1 W/cm$^2$

Films coated in dynamic deposition mode

The electrical properties of the coatings were measured using a 4-point probe to determine resistivity. The optical properties in terms of reflectivity were measured at a wavelength range of from 250 to 1100 nm as described above.

Film resistivity of the AgIn and AgInAl alloys layers of 350 nm thickness resulted in the same value, amounting to 3.2 $\mu\Omega$cm.

Reflectivity on 200 nm layers is depicted in Figs 1 and 2. As can be seen, the AgInAl alloy layer shows a higher reflectivity than the AgIn alloy layer, although reflectivity of the unalloyed Ag layer is the highest (cf. Fig. 1).

As depicted in Fig. 2, Al does not enhance reflectivity of the unalloyed Ag layer. It rather has an impairing effect on reflectivity.

**Claims**

1. A sputtering target comprising an AgXAl alloy consisting of Ag, from 0.20 to 0.80 wt.-% of an alloying metal X, which is selected from the group consisting of In, Sn, Sb and Bi and any combination thereof, and from 100 to 300 ppm-wt. of Al.

2. The sputtering target according to claim 1, wherein the alloying metal X is In.

3. The sputtering target according to any one of the preceding claims, wherein the AgXAl alloy consists of Ag, from 0.30 to 0.70 wt.-%, preferably from 0.40 to 0.60 wt.-%, of X, and further from 120 to 250 ppm-wt., preferably from 150 to 220 ppm-wt., of Al.

4. The sputtering target according to any one of the preceding claims, wherein the AgXAl alloy has an average grain size in the range of from 10 to less than 150 $\mu$m.

5. The sputtering target according to any one of the preceding claims, wherein the AgXAl alloy has a metallic purity of at least 99.9 wt.-% (3N), preferably at least 99.95 wt.-% (3N5).

6. The sputtering target according to any one of the preceding claims, wherein the AgXAl alloy has an oxygen content of less than 50 ppm-wt., preferably less than 20 ppm-wt., more preferably less than 10 ppm-wt. and even more preferably less than 5 ppm-wt.

7. The sputtering target according to any one of the preceding claims, wherein not more than two inclusion clusters of Al in the form of an oxide with a cluster size of more than 1 $\mu$m$^2$ are detectable in an area of 1 mm$^2$, for a total of five areas at arbitrary positions of a scanning electron microscopy (SEM) sample, and measured as described in the specification.

8. The sputtering target according to any one of the preceding claims, wherein the deposited AgXAl alloy film has a higher reflectivity than an AgX alloy of the same X content but without Al, determined by spectroscopy on a sputtered 200 nm layer at a wavelength 550 nm.

9. A process for producing the sputtering target according to any one of the preceding claims, comprising preparing the AgXAl alloy by heating Ag metal pieces in an inert container to a temperature range of from 980 to 1200 °C under vacuum or at inert gas conditions in the presence of Al and the alloying metal X.

10. A sputtering target prepared by the process according to claim 9.

11. A layer formed by sputtering the AgXAl alloy from the sputtering target according to any one of claims 1 to 8 or 10 on a substrate.

12. Use of Al in an AgX alloy to enhance reflectivity of a sputtered layer of an AgX alloy, wherein X is an alloying metal, selected from the group consisting of In, Sn, Sb and Bi and any combination thereof.

13. Use according to claim 12, wherein the AgX alloy consists of Ag and from 0.20 to 0.80 wt.-% of the alloying metal X.

14. Use according to claim 12 or 13, wherein Al is used in an amount of from 100 to 300 ppm-wt.

15. Use according to any one of claims 12 to 14, wherein an AgXAl alloy is formed by the use.

Fig. 1:

Fig. 2:

Europäisches
Patentamt

European
Patent Office

Office européen
des brevets

# EUROPEAN SEARCH REPORT

**Application Number**

EP 24 16 0774

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/264200 A1 (SCHLOTT MARTIN [DE] ET AL) 10 October 2013 (2013-10-10) * paragraphs [0002], [0003], [0006], [0051]; table 1 * | 1-15 | INV. C23C14/34 |
| A | JP 2016 194108 A (MITSUBISHI MATERIALS CORP) 17 November 2016 (2016-11-17) * paragraphs [0001], [0007], [0023]; table 1 * | 1-15 | |

TECHNICAL FIELDS
SEARCHED        (IPC)

C23C
C22C

The present search report has been drawn up for all claims

| Place of search | Date of completion of the search | Examiner |
|---|---|---|
| The Hague | 11 September 2024 | Schafranek, Robert |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 16 0774

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2024

| Patent document cited in search report | Publication date | Patent family member(s) | Publication date |
|---|---|---|---|
| US 2013264200 A1 | 10-10-2013 | CN 103361506 A | 23-10-2013 |
| | | DE 102012006718 B3 | 18-07-2013 |
| | | EP 2647737 A1 | 09-10-2013 |
| | | JP 5479627 B2 | 23-04-2014 |
| | | JP 2013216976 A | 24-10-2013 |
| | | KR 20130112806 A | 14-10-2013 |
| | | KR 20150035888 A | 07-04-2015 |
| | | TW 201400633 A | 01-01-2014 |
| | | US 2013264200 A1 | 10-10-2013 |
| JP 2016194108 A | 17-11-2016 | JP 6481473 B2 | 13-03-2019 |
| | | JP 2016194108 A | 17-11-2016 |

**REFERENCES CITED IN THE DESCRIPTION**

**Patent documents cited in the description**

- EP 2647737 A1

- EP 3168325 A1